(19) Europäisches Patentamt
European Patent Office
Office européen des brevets

(11) **EP 4 481 412 A1**

(12) # EUROPEAN PATENT APPLICATION

(43) Date of publication:
**25.12.2024 Bulletin 2024/52**

(21) Application number: **23209475.5**

(22) Date of filing: **13.11.2023**

(51) International Patent Classification (IPC):
**G01R 31/367** (2019.01)   **G01R 31/374** (2019.01)
**G01R 31/392** (2019.01)

(52) Cooperative Patent Classification (CPC):
**G01R 31/392; G01R 31/367; G01R 31/374**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **19.06.2023 CN 202310737862**

(71) Applicant: **Sungrow Power Supply Co., Ltd.
Hefei, Anhui 230088 (CN)**

(72) Inventors:
• **LIANG, Dongyu**
  **Hefei, Anhui (CN)**
• **DING, Huaidong**
  **Hefei, Anhui (CN)**
• **CAO, Ying**
  **Hefei, Anhui (CN)**

(74) Representative: **Zacco Norway AS
P.O. Box 488 Skøyen
0213 Oslo (NO)**

(54) **METHOD AND APPARATUS FOR MANAGING STATE OF HEALTH OF BATTERY, ELECTRONIC DEVICE, AND STORAGE MEDIUM**

(57)     A method and an apparatus for managing state of health of a battery, an electronic device, and a storage medium are provided. The method includes: acquiring cell life cycle data corresponding to a to-be-detected battery; determining total discharge capacity of the to-be-detected battery based on the cell life cycle data; collecting a discharge current of the to-be-detected battery; calculating first discharge capacity of the to-be-detected battery based on the discharge current; and calculating the state of health of the to-be-detected battery based on the total discharge capacity and the first discharge capacity. The first discharge capacity is determined based on the discharge current of the to-be-detected battery. The state of health is calculated based on the total discharge capacity and the first discharge capacity. Therefore, an estimation accuracy of the SOH of a battery is improved. Therefore, the state of health of the battery can be estimated accurately.

**Figure 2**

**Description**

**FIELD**

The present disclosure relates to the technical field of battery management, and in particular, to a method and an apparatus for managing state of health of a battery, an electronic device and a storage medium.

**BACKGROUND**

State of health (SOH) is often utilized as a basis and standard for operation, management, maintenance and repair of a battery.

Conventionally, the SOH is estimated through capacity calibration or based on the number of cycles, having the following problems.

To estimate the SOH through capacity calibration, a battery has to be fully discharged once and fully charged once to obtain a true capacity (SOH_now) of the battery currently. Then, the true capacity (SOH_now) is divided by a rated capacity (SOH_nominal) of the fresh battery, so as to obtain the SOH of the battery.

The number of cycles is calculated based on total energy charged and discharged to estimate the SOH based on the number of cycles. The battery capacity decreases and thus has to be calibrated to obtain the cumulative number of cycles. The total number of cycles in the lifespan of the battery is also estimated.

After a certain number of charge-discharge cycles, an allowable charge/discharge current is decreased, in a case that a current limiting matrix is solidified.

Based on the above, estimation of the SOH as described above results in poor accuracy.

**SUMMARY**

In view of this, a method and an apparatus for managing state of health of a battery, an electronic device, and a storage medium are provided according to embodiments of the present disclosure provide, in order to solve the problem of poor estimation accuracy in the conventional technology.

Technical solutions provided according to the embodiments of the present disclosure for achieving the above purpose are described below.

In a first aspect, a method for managing state of health of a battery is provided. The method includes: acquiring cell life cycle data corresponding to a to-be-detected battery; determining total discharge capacity of the to-be-detected battery based on the cell life cycle data; collecting a discharge current of the to-be-detected battery; calculating first discharge capacity of the to-be-detected battery based on the discharge current; and calculating the state of health of the to-be-detected battery based on the total discharge capacity and the first discharge capacity.

In an embodiment, the determining the total discharge capacity of the to-be-detected battery based on the cell life cycle data includes: determining a battery life cycle, battery rated capacity and a battery capacity retention rate from the cell life cycle data; and calculating a product of the battery life cycle, the battery rated capacity and the battery capacity retention rate as the total discharge capacity of the to-be-detected battery.

In an embodiment, the method further includes: acquiring a battery type of the to-be-detected battery; and searching a battery capacity experimental data table based on the battery type to determine the total discharge capacity corresponding to the to-be-detected battery, and proceeding to the collecting the discharge current of the to-be-detected battery, where the battery capacity experimental data table is generated based on the cell life cycle data.

In an embodiment, the battery capacity experimental data table is generated based on the cell life cycle data by: acquiring cell life cycle data of batteries corresponding to multiple battery types; determining, for each of the battery types, total discharge capacity of a battery corresponding to the battery type based on the cell life cycle data of the batteries; and storing total discharge capacities corresponding to the batteries, and the battery types to the battery capacity experimental data table.

In an embodiment, the method further includes: acquiring a cell temperature, a battery SOC, and a voltage of the to-be-detected battery, where the cell temperature is N in number, the voltage is M in number, and N and M are both positive integers greater than or equal to 2; and determining a target discharge current range and a target charge current range based on the cell temperature, the battery SOC and the voltage.

In an embodiment, the determining the target discharge current range and the target charge current range based on the cell temperature, the battery SOC and the voltage includes: arranging the N cell temperatures in descending order; arranging the M voltages in descending order; and determining the target discharge current range and the target charge current range based on the first cell temperature, the Nth cell temperature, the first voltage, the Mth voltage and the battery SOC.

In an embodiment, the determining the target discharge current range and the target charge current range based on the first cell temperature, the Nth cell temperature, the first voltage, the Mth voltage and the battery SOC includes: querying a current limiting matrix in a data table based on the first cell temperature, the first voltage and the battery SOC, to determine a first discharge current and a first charge current; and querying the current limiting matrix in the data table based on the Nth cell temperature, the Mth voltage and the battery SOC, to determine a second discharge current and a second charge current.

In an embodiment, the method further includes: determining whether the calculated state of health of the to-be-detected battery is lower than previous state of health, where the previous state of health is set to an initial value in a case that the state of health of the to-be-detected battery is calculated for the first time; and correcting the target discharge current range and the target charge current range based on the calculated state of health of the to-be-detected battery, if determined that the calculated state of health is lower than the previous state of health.

In an embodiment, the method further includes: determining an initial current limiting matrix based on the battery rated capacity in the cell life cycle data; and determining the target discharge current range and the target charge current range based on the initial current limiting matrix.

In a second aspect, an apparatus for managing state of health of a battery is provided. The apparatus includes: an acquiring unit, a determining unit, a collecting unit and a processing unit. The acquiring unit is configured to acquire cell life cycle data corresponding to a to-be-detected battery. The determining unit is configured to determine total discharge capacity of the to-be-detected battery based on the cell life cycle data. The collecting unit is configured to collect a discharge current of the to-be-detected battery. The processing unit is configured to calculate first discharge capacity of the to-be-detected battery based on the discharge current, and calculate the state of health of the to-be-detected battery based on the total discharge capacity and the first discharge capacity.

In a third aspect, an electronic device is provided. The electronic device is configured to execute a program. The program, when executed, performs the method according to the first aspect of the present disclosure.

In a fourth aspect, a computer storage medium, storing a program, is provided. The program, when executed, controls a device where the storage medium is located to perform the method according to the first aspect of the present disclosure.

The method and the apparatus for managing state of health of a battery, the electronic device, and the storage medium are provided in the embodiments of the present disclosure. The method includes: acquiring cell life cycle data corresponding to a to-be-detected battery; determining total discharge capacity of the to-be-detected battery based on the cell life cycle data; collecting a discharge current of the to-be-detected battery; calculating first discharge capacity of the to-be-detected battery based on the discharge current; and calculating the state of health of the to-be-detected battery based on the total discharge capacity and the first discharge capacity. The first discharge capacity is determined based on the discharge current of the to-be-detected battery. The state of health is calculated based on the total discharge capacity and the first discharge capacity. Therefore, an estimation accuracy of the SOH of a battery is improved. Therefore, the state of health of the battery can be estimated accurately.

## BRIEF DESCRIPTION OF THE DRAWINGS

For clearer illustration of the technical solutions according to embodiments of the present disclosure or conventional techniques, hereinafter briefly described are the drawings to be applied in embodiments of the present disclosure or conventional techniques. Apparently, the drawings in the following descriptions are only some embodiments of the present disclosure, and other drawings may be obtained by those skilled in the art based on the provided drawings without any creative effort.

Figure 1 is a schematic structural diagram of a battery according to an embodiment of the present disclosure;

Figure 2 is a flow chart of a method for managing state of health of a battery according to an embodiment of the present disclosure;

Figure 3 is a flow chart of a method for managing state of health of a battery according to an embodiment of the present disclosure;

Figure 4 is a flow chart of a method for managing state of health of a battery according to an embodiment of the present disclosure;

Figure 5 is a flow chart of a method for managing state of health of a battery according to an embodiment of the present disclosure; and

Figure 6 is a schematic structural diagram of an apparatus for managing state of health of a battery according to an embodiment of the present disclosure.

## DETAILED DESCRIPTION

Hereinafter technical solutions of embodiments of the present disclosure are described clearly and completely in conjunction with the drawings of the embodiments of the present disclosure. Apparently, the embodiments described below are only some rather than all the embodiments of the present disclosure. Any other embodiments obtained by those skilled in the art based on the embodiments in the present disclosure without any creative effort shall fall within the protection scope of the present disclosure.

The terms such as "first", "second", "third", "fourth" and the like (if necessary) in the description, claims and drawings are only used to distinguish similar objects, rather than describe a particular sequence or order. It should be understood that data used in such manner may be interchanged appropriately, so that the embodiments of the present disclosure may be implemented in an order other than those illustrated or described herein. Moreover, the terms "include (comprise)", "have", and any other variants thereof are intended to cover a non-exclusive inclusion. For example, a process, method, system, product, or device that includes a list of steps or units is not necessarily limited to the expressly listed steps or units, but may include other steps or units not expressly listed or inherent in the process, method, product, or device.

It should be noted that descriptions involving "first", "second", and the like, in the present disclosure are for descriptive purposes instead of indicating or implying relative importance or implicitly indicating quantities of indicated technical features. Therefore, a feature defined with "first" and "second" may explicitly or implicitly include at least one of the features. In addition, the technical solutions in the embodiments may be combined with each other, with a basis that those of ordinary skills in the art are capable of implementing the such combination.

In the present disclosure, terms of "include", "comprise" or any other variants are intended to be non-exclusive. Therefore, a process, method, article or device including a series of elements includes not only the elements but also other elements that are not enumerated, or further includes the elements inherent in the process, method, article or device. Unless expressively limited otherwise, the statement "comprising (including) one..." does not exclude existence of other similar elements in the process, method, article or device.

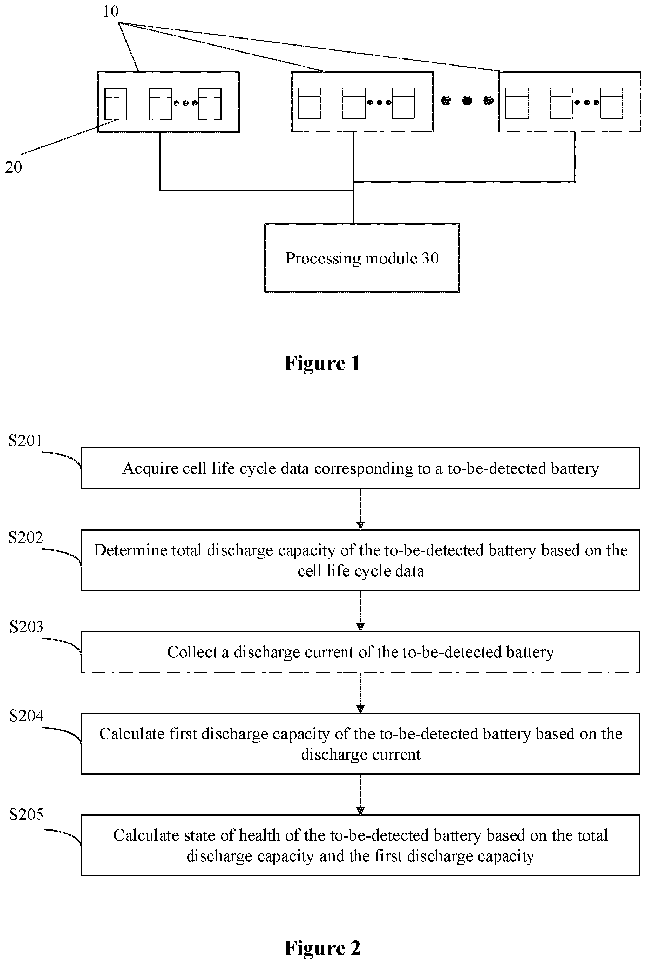

Reference is made to Figure 1, which is a schematic structural diagram of a battery according to an embodiment of the present disclosure.

The battery includes multiple modules 10 connected in series. Each of the modules includes multiple cells 20.

The modules in the battery are connected to a processing module 30 in the battery.

It should be noted that the processing module 30 includes a state of charge (SOC) collector for collecting a battery SOC, a voltage collector for collecting a cell voltage, and a temperature collector for collecting a cell temperature.

Details about the management of the state of health of the battery by the processing module 30 in the battery are as follows.

The processing module 30 acquires cell life cycle data corresponding to a to-be-detected battery; determines total discharge capacity of the to-be-detected battery based on the cell life cycle data; collects a discharge current of the to-be-detected battery; calculates first discharge capacity of the to-be-detected battery based on the discharge current; and calculates the state of health of the to-be-detected battery based on the total discharge capacity and the first discharge capacity.

In the embodiments of the present disclosure, the state of health of the battery is evaluated based on the discharge capacity. The first discharge capacity is determined by collecting the discharge current of the to-be-detected battery. The state of health of the to-be-detected battery is obtained based on the total discharge capacity and the first discharge capacity. Therefore, the SOH of the battery can be estimated accurately.

Reference is made to Figure 2, which is a flow chart of a method for managing a state of health of a battery according to an embodiment of the present disclosure. The method includes the following steps S201 to S205.

In S201, cell life cycle data corresponding to a to-be-detected battery is acquired.

The cell life cycle data includes a battery life cycle, battery rated capacity, a battery capacity retention rate, and other parameters.

It should be noted that batteries may be classified into various categories, including an electrolyte battery, an acid battery, a primary battery, a secondary battery, a fuel cell, a reserve battery, and the like.

In an embodiment, a charge-discharge test is performed on multiple types of batteries in advance to collect the cell life cycle data corresponding to each type.

In an implementation of S201, the cell life cycle data corresponding to a type the to-be-detected battery is obtained.

In S202, total discharge capacity of the to-be-detected battery is determined based on the cell life cycle data.

It is to be noted that an implementation of determining the total discharge capacity of the to-be-detected battery based on the cell life cycle data in S202 includes the following steps S11 to S12.

In S11, a battery life cycle, a battery rated capacity and a battery capacity retention rate are determined from the cell life cycle data.

In an implementation of S11, the battery life cycle, the battery rated capacity and the battery capacity retention rate are obtained from the cell life cycle data.

In S 12, a product of the battery life cycle *cycle,* the battery rated capacity CAP_nominal and the battery capacity retention rate K is calculated, as the total discharge capacity CAP_life of the to-be-detected battery.

In S12, the battery life cycle *cycle,* the battery rated capacity CAP_nominal and the battery capacity retention rate K are substituted into the following equation (1) to calculate the total discharge capacity CAP_life of the to-be-detected battery.

$$CAP\_life = cycle*CAP\_nominal*K \qquad (1)$$

In equation (1), cycle represents the battery life cycle, CAP_nominal represents the battery rated capacity, and K represents the battery capacity retention rate.

In step S203, a discharge current of the to-be-detected battery is collected.

In an implementation of step S203, the current discharge current of the to-be-detected battery is collected.

In step S204. first discharge capacity of the to-be-detected battery is calculated based on the discharge current.

In an implementation of step S204, the discharge current is calculated through an ampere-hour integral method, that is, the discharge current is substituted into the following equation (2) to calculate the first discharge capacity of the to-be-detected battery.

$$CAP\_now = \int (current)dt \qquad (2)$$

In equation (2), current represents the discharge current, and CAP_now represents the first discharge capacity.

It should be noted that the discharge capacity is accumulated form the equation (2) in order to estimate the state of health by dividing the accumulated discharge capacity by the total discharge capacity.

In step S205, the state of health of the to-be-detected battery is calculated based on the total discharge capacity and the first discharge capacity.

In an implementation of step S205, a ratio of the first discharge capacity to the total discharge capacity is calculated as the state of health of the to-be-detected battery. That is, the first discharge capacity CAP_now and the total discharge capacity CAP_life are substituted into the following equation (3) to obtain the current state of health of the to-be-detected battery.

$$SOH=CAP\_now/CAP\_life \qquad (3)$$

According to the embodiments of the present disclosure, the cell life cycle data corresponding to the to-be-detected battery is obtained. The total discharge capacity of the to-be-detected battery is determined based on the cell life cycle data. The discharge current of the to-be-detected battery is collected. The first discharge capacity of the to-be-detected battery is determined based on the discharge current. The state of health of the to-be-detected battery is calculated based on the total discharge capacity and the first discharge capacity. The state of health is evaluated based on the discharge capacity. The first discharge capacity is determined based on the discharge current of the to-be-detected battery, so that the state of health is obtained. Therefore, the state of health of the battery can be estimated accurately. Such estimation is suitable to the lifespan of the battery.

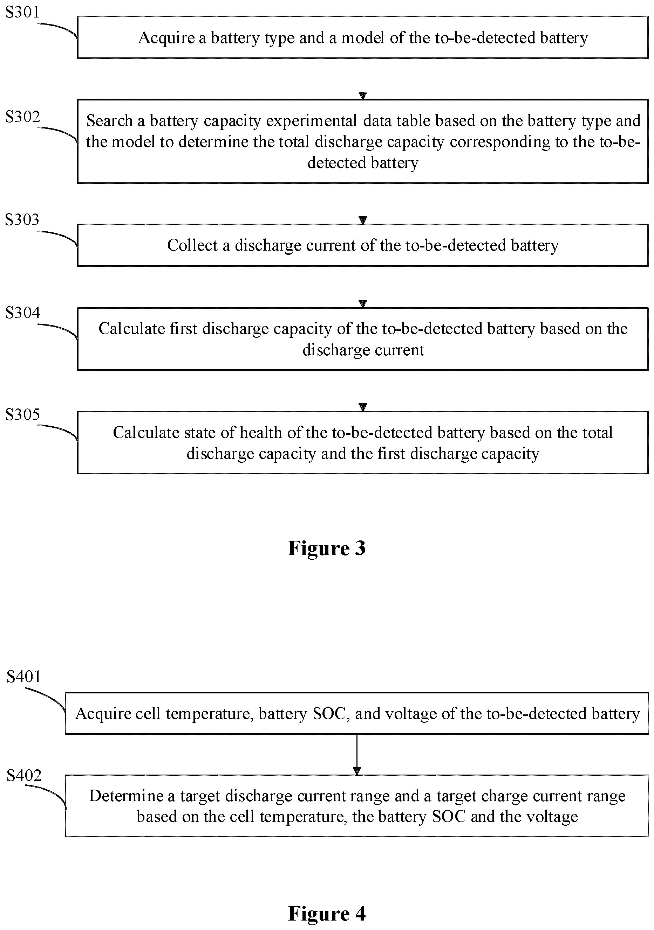

Based on the above embodiments, a method for managing state of health of battery is further provided according to another embodiment of the present disclosure. As shown in Figure 3, the method includes the following steps S301 to S305.

In step S301, a battery type of the to-be-detected battery is acquired.

It should be noted that an implementation of step S301 is the same as the implementation of step S201 mentioned above, which may be referred to each other.

In step S302, a battery capacity experimental data table is searched based on the battery type to determine the total discharge capacity corresponding to the to-be-detected battery.

The battery capacity experimental data table is generated based on the cell life cycle data.

It should be noted that the battery capacity experimental data table is generated based on the cell life cycle data through the following steps S21 to S23.

In step S21, cell life cycle data of batteries corresponding to multiple battery types is obtained.

In an implementation of S21, a charge-discharge test is performed on the multiple types of batteries in advance to collect the cell life cycle data corresponding to each battery type.

In step S22, for each of the battery types, total discharge capacity of a battery corresponding to the battery type is determined based on the cell life cycle data of the batteries.

In an implementation of step S22, for each of the battery types, a battery life cycle, battery rated capacity and a battery capacity retention rate in the cell life cycle data are substituted into the equation (1) to obtain the total discharge capacity of a battery corresponding to the battery type.

In step S23, total discharge capacities corresponding to the batteries, and the battery types are stored in the battery capacity experimental data table.

In an implementation of step S23, a correspondence relationship between the total discharge capacities of the batteries and the battery types is created and stored to the battery capacity experimental data table.

In step S303, a discharge current of the to-be-detected battery is collected.

In step S304, first discharge capacity of the to-be-detected battery is calculated based on the discharge current.

In step S305, state of health of the to-be-detected battery is calculated based on the total discharge capacity and the first discharge capacity.

It should be noted that implementations of steps S303 to S305 are the same as the implementations of step S203 to S205, which may be referred to each other.

According to the embodiments of the present disclosure, the cell life cycle data corresponding to the to-be-detected battery is obtained. The total discharge capacity of the to-be-detected battery is determined based on the cell life cycle data. The discharge current of the to-be-detected battery is collected. The first discharge capacity of the to-be-detected battery is calculated based on the discharge current. The state of health of the to-be-detected battery is obtained based on the total discharge capacity and the first discharge capacity. The state of health is evaluated based on the discharge capacity. The first discharge capacity is determined based on the discharge current of the to-be-detected battery, so that the state of health is obtained. Therefore, the state of health of the battery can be estimated accurately. Such estimation is suitable for the lifespan of the battery.

In an embodiment, the battery includes multiple modules. Each of the modules includes multiple cells. Reference is made to Figure 4. Based on the method shown in the above embodiment, the method further includes the following steps S401 to S402.

In step S401, a cell temperature, a battery SOC, and a voltage of the to-be-detected battery are obtained.

The number of cell temperatures is N, the number of voltages is M, where N and M are both positive integers greater than or equal to 2.

It should be noted that N is equal to M, and N and M each represent the number of cells.

In an implementation of step S401, the battery SOC of the to-be-detected battery is sensed in real time by an SOC collector, a current voltage of each cell is sensed in real time by a voltage collector, and a cell temperature of each cell is sensed in real time by a temperature collector. That is, N cell temperatures and M voltages are obtained.

In step S402, a target discharge current range and a target charge current range are determined based on the cell temperature, the battery SOC and the voltage.

It should be noted that an implementation of step S402 includes the following steps S31 to S33.

In step S31, the N cell temperatures are arranged in descending order.

In step S32, the M voltages are arranged in descending order.

In step S33, the target discharge current range and the target charge current range are determined based on the first cell temperature, the Nth cell temperature, the first voltage, the Mth voltage and the battery SOC.

It should be noted that an implementation of step S33 includes the following steps S41 to S44.

In step S41, a current limiting matrix in a data table is queried based on the first cell temperature, the first voltage and the battery SOC, to determine a first discharge current and a first charge current.

In the present disclosure, a first discharge current, a second discharge current, a first charge current and a second charge current corresponding to the temperature, the voltage and the SOC are calibrated and stored in a form of the current limiting matrix.

In an implementation of step S41, a data table is queried based on a maximum cell temperature, a maximum voltage and the battery SOC, to determine the current limiting matrix corresponding to the first cell temperature, the first voltage and the battery SOC, thereby determining the first discharge current and the first charge current from the current limiting matrix.

It should be noted that the first discharge current refers to a maximum allowable discharge current of the battery at present, and the first charge current refers to a maximum allowable charge current of the battery at present.

In step S42, the current limiting matrix in the data table is queried based on the Nth cell temperature, the Mth voltage and the battery SOC, to determine a second discharge current and a second charge current.

In an implementation of step S42, the data table is queried for the minimum cell temperature, the minimum voltage, and the battery SOC, to determine a current limiting matrix corresponding to the Nth cell temperature, the Mth voltage and the battery SOC, and thereby determining the second discharge current and the second charge current from the current limiting matrix.

It should be noted that the second discharge current refers to a minimum allowable discharge current of the battery at present, and the second charge current refers to a minimum allowable charge current of the battery at present.

In step S43, a closed interval between the first discharge current and the second discharge current is determined as the target discharge current range.

In an implementation of step S43, the first discharge current and the second discharge current are determined as end points of the closed interval to determine a range from the second discharge current to the first discharge current, as the target discharge current range.

In step S44, a closed interval between the first charge current and the second charge current is determined as the target charge current range.

In an implementation of step S44, the first charge current and the second charge current are determined as end points of the closed interval to determine a range from the second charge current to the first charge current, as the target charge current range.

In the embodiments, the cell temperature, the battery SOC, and the voltage of the to-be-detected battery are obtained. The target discharge current range and the target charge current range are determined based on the cell temperature, the battery SOC and the voltage. The current limiting matrix is established based on the SOC, the temperature and the voltage. This solution adopts a dynamic current limiting matrix to more accurately evaluate the maximum allowable charge current and the maximum allowable discharge current of the battery. Therefore, the state of health of the battery and the number of cycles of the battery throughout the lifespan can be estimated accurately.

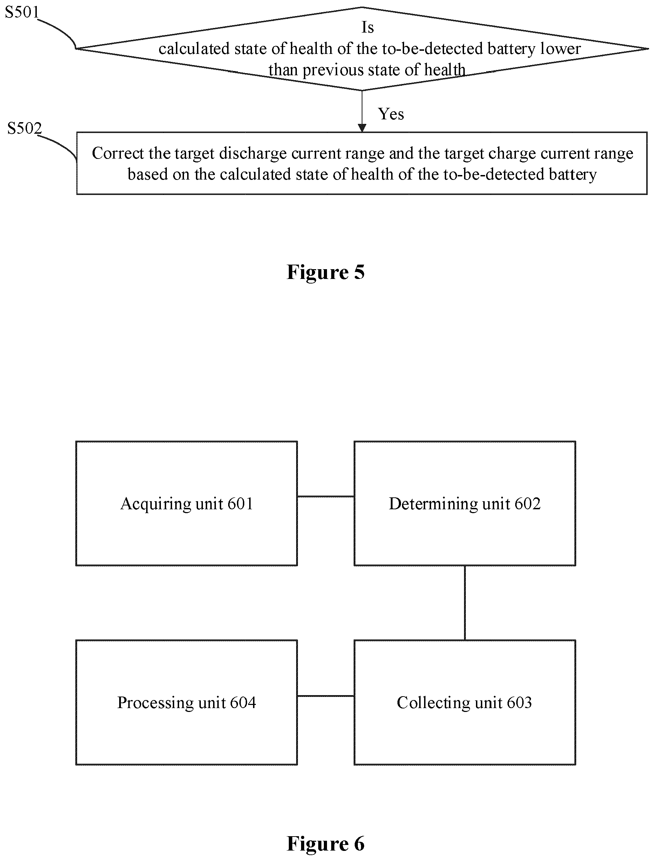

Reference is made to Figure 5. In the embodiments, based on the embodiment shown in the above embodiment, the method further includes the following steps S501 to S502.

In step S501, it is determined whether the calculated state of health of the to-be-detected battery currently is lower than previous state of health. The method proceeds to step S502 if the calculated state of health of the to-be-detected battery is lower than the previous state of health. If the calculated state of health of the to-be-detected battery is higher than or equal to the previous state of health, the target discharge current range and the target charge current range remain unchanged and are stored.

In step S501, the previous state of health is set to an initial value if the state of health of the to-be-detected battery is calculated for the first time.

It should be noted that the initial value means that the SOH is equal to 100%.

In an implementation of step S501, the calculated state of health of the to-be-detected battery is compared to the previous state of health. The method proceeds to step S502 if determined that the calculated state of health of the to-be-detected battery is lower than the previous state of health. If the calculated state of health of the to-be-detected battery is higher than or equal to the previous state of health, the calculated target discharge current range and the calculated target charge current range remain unchanged and are stored.

It should be noted that the number of times for calculating the state of health of the to-be-detected battery depends on practical applications.

In step S502, the target discharge current range and the target charge current range are corrected based on the state of health of the to-be-detected battery.

In an implementation of step S502, the state of health of the to-be-detected battery is determined as a correction coefficient of the current limiting matrix. The state of health of the to-be-detected battery is multiplied by the first discharge current in the target discharge current range to obtain the updated first discharge current, and the state of health of the to-be-detected battery is multiplied by the second discharge current in the target discharge current range to obtain the updated second discharge current. The updated first discharge current and the updated second discharge current form the updated target discharge current range. Similarly, the state of health of the to-be-detected battery is multiplied by the first charge current in the target charge current range to obtain the updated first charge current, and the state of health of the to-be-detected battery is multiplied by the second charge current in the target charge current range to obtain the updated second charge current. The updated first charge current and the updated second charge current form the updated target charge current range, which is expressed as the equation (4) below.

$$POWER\_LIMIT\_NOW[SOC, Temp, Vol] = SOH\_now * POWER\_LIMIT\_INIT[SOC, Temp, Vol] \quad (4)$$

In the embodiments, the updated first discharge current, the updated second discharge current, the updated first charge current and the updated second charge current are stored, that is, the current limiting matrix is updated.

In the embodiments, it is determined whether the calculated state of health of the to-be-detected battery is lower than the previous state of health. The target discharge current range and the target charge current range are corrected based on the calculated state of health of the to-be-detected battery if the calculated state of health of the to-be-detected battery is lower than the previous state of health. This solution adopts a dynamic current limiting matrix to more accurately evaluate the maximum allowable charge and discharge current of the battery. Therefore, the state of health of the battery and the number of charge-discharge cycles of the battery throughout the lifespan can be estimated accurately.

In the embodiments, the method further includes steps S51 to S52.

In step S51, an initial current limiting matrix is determined based on the battery rated capacity in the cell life cycle data.

In step S51, the initial current limiting matrix is established based on the voltage, the charge current, the discharge current, and the battery SOC.

It should be noted that a relationship between the battery rated capacity and the initial current limiting matrix is established in advance.

In an implementation of step S51, the to-be-detected battery is initialized in first use. For example, the initial current limiting matrix corresponding to the battery rated capacity in the cell life cycle data is determined by searching the relationship between the battery rated capacity and the initial current limiting matrix.

The initial current limiting matrix is constructed based on the voltage, the charge current, the discharge current, the battery SOC, and also the first discharge current, the second discharge current, the first charge current and the second charge current.

In step S52, the target discharge current range and the target charge current range are determined based on the initial current limiting matrix.

In an implementation of step S52, the first discharge current and the second discharge current in the initial current limiting matrix are determined as the target discharge current range. The first charge current and the second charge current in the initial current limiting matrix are determined as the target charge current range.

In the embodiments, the initial current limiting matrix is determined based on the battery rated capacity in the cell life cycle data. The target discharge current range and the target charge current range is determined based on the initial current limiting matrix. This solution adopts a dynamic current limiting matrix to more accurately evaluate the maximum allowable charge current and the maximum allowable discharge current of the battery. Therefore, the state of health of the battery and the number of cycles of the battery throughout the lifespan can be estimated accurately.

Based on the method shown in the above embodiment, an apparatus for managing state of health of a battery is provided. As shown in Figure 6, the apparatus includes an acquiring unit 601, a determining unit 602, a collecting unit 603 and a processing unit 604.

The acquiring unit 601 is configured to acquire cell life cycle data corresponding to a to-be-detected battery.

The determining unit 602 is configured to determine total discharge capacity of the to-be-detected battery based on the cell life cycle data.

The collecting unit 603 is configured to collect a discharge current of the to-be-detected battery.

The processing unit 604 is configured to calculate first discharge capacity of the to-be-detected battery based on the discharge current; and calculate the state of health of the to-be-detected battery based on the total discharge capacity and the first discharge capacity.

It should be noted that specific principles and operations of the units in the apparatus disclosed in the embodiments of the present disclosure are the same as the principles and operations of the method shown in previous embodiments of the present disclosure. Reference may be made to the corresponding parts of the method, and therefore the apparatus is not detailed herein.

According to the embodiments of the present disclosure, the cell life cycle data corresponding to the to-be-detected battery is acquired. The total discharge capacity of the to-be-detected battery is determined based on the cell life cycle data. The discharge current of the to-be-detected battery is collected. The first discharge capacity of the to-be-detected battery is calculated based on the discharge current. The state of health of the to-be-detected battery is calculated based on the total discharge capacity and the first discharge capacity. The state of health is evaluated based on the discharge capacity. The first discharge capacity is determined based on the discharge current of the to-be-detected battery, so that the state of health is obtained. Therefore, the state of health of the battery can be estimated accurately. Such estimation is suitable for the lifespan of the battery.

In the embodiments, the determining unit 602 is configured to: determine a battery life cycle, battery rated capacity and a battery capacity retention rate from the cell life cycle data; and calculate a product of the battery life cycle, the battery rated capacity and the battery capacity retention rate, as the total discharge capacity of the to-be-detected battery.

In the embodiments, the processing unit 604 is further configured to: acquire a battery type of the to-be-detected battery; and search a battery capacity experimental data table based on the battery type to determine the total discharge capacity corresponding to the to-be-detected battery. The battery capacity experimental data table is generated based on the cell life cycle data.

In the embodiments, the processing unit 604 is configured to generate the battery capacity experimental data table based on the cell life cycle data by: acquiring cell life cycle data of batteries corresponding to multiple battery types; determining, for each of the battery types, total discharge capacity of a battery corresponding to the battery type based on the cell life cycle data of the batteries; and storing total discharge capacities corresponding to the batteries, and the battery types to the battery capacity experimental data table.

In the embodiments, the processing unit 604 is further configured to: acquire a cell temperature, a battery SOC, and a voltage of the to-be-detected battery, where the cell temperature is N in number, the voltage is M in number, where N and M are both positive integers greater than or equal to 2; and determine a target discharge current range and a target charge current range based on the cell temperature, the battery SOC and the voltage.

In the embodiments, the processing unit 604 is configured to determine the target discharge current range and the target charge current range based on the cell temperature, the battery SOC and the voltage by: arranging the N cell temperatures in descending order; arranging the M voltages in descending order; and determining the target discharge current range and the target charge current range based on the first cell temperature, the Nth cell temperature, the first voltage, the Mth voltage and the battery SOC.

It should be noted that the determining the target discharge current range and the target charge current range based on the first cell temperature, the Nth cell temperature, the first voltage, the Mth voltage and the battery SOC includes: querying a current limiting matrix in a data table based on the first cell temperature, the first voltage and the battery SOC, to determine a first discharge current and a first charge current; and querying the current limiting matrix in the data table based on the Nth cell temperature, the Mth voltage and the battery SOC, to determine a second discharge current and a second charge current.

In the embodiments, the processing unit 604 is further configured to: determine whether the calculated state of health of the to-be-detected battery is lower than previous state of health, where the previous state of health is set to an initial value in a case that the state of health of the to-be-detected battery is calculated for the first time; and correct the target discharge current range and the target charge current range based on the calculated state of health of the to-be-detected battery, if determined that the calculated state of health is lower than the previous state of health.

In the embodiments, the processing unit 604 is further configured to: determine an initial current limiting matrix based on the battery rated capacity in the cell life cycle data; and determine the target discharge current range and the target charge current range based on the initial current limiting matrix.

An electronic device is further provided according to an embodiment of the present disclosure. The electronic device is configured to execute database storage to perform the method as disclosed in Figure 2 to Figure 5.

A storage medium is further provided according to an embodiment of the present disclosure. The storage medium stores database storage. The database storage process, when executed, controls a device where the storage medium is located to perform the method as disclosed in Figure 2 to Figure 5.

The embodiments in the present disclosure are described in a progressive manner. The same and similar parts among the embodiments may be referred to each other. Each of the embodiments focuses on its differences from the other embodiments. The system or system embodiments are essentially similar to the method embodiments, and therefore are described in brief. Reference may be made to the description of the method embodiments for relevant details of the system or system embodiments. The systems and system embodiments described above are only illustrative. The units described as separate components may or may not be physically separated. Components shown as units may or may not be physical units, that is, the components may be located at a same position or distributed among multiple network units. Some or all of the modules may be adopted as needed to achieve the purpose of the solutions in the embodiments of the present disclosure. Those of ordinary skills in the art can understand and implement the method without any creative effort.

Those skilled in the art may further understand that, units and algorithm steps described in conjunction with the embodiments disclosed herein may be realized by electronic hardware, computer software or a combination thereof. In order to clearly describe interchangeability of the hardware and the software, the units and steps of each embodiment are generally described above according to functions. Whether a function is to be implemented by hardware or software depends on a particular application of the technical solutions and design constraints. Those skilled in the art may implement the described functions in various manners for each specific application.

The embodiments are described above, so that those skilled in the art can implement or use the present disclosure. Various modifications to the embodiments are apparent to those skilled in the art, and the generic principles defined herein may be practiced in other embodiments without departing from the spirit or scope of the present disclosure. Therefore, the present disclosure is not to be limited to the embodiments shown herein but is to be conformed with the widest scope consistent with the principles and novel features disclosed herein.

**Claims**

1. A method for managing state of health of a battery, comprising:

acquiring cell life cycle data corresponding to a to-be-detected battery;

determining total discharge capacity of the to-be-detected battery based on the cell life cycle data;

collecting a discharge current of the to-be-detected battery;

calculating first discharge capacity of the to-be-detected battery based on the discharge current; and

calculating the state of health of the to-be-detected battery based on the total discharge capacity and the first discharge capacity.

2.  The method according to claim 1, wherein the determining the total discharge capacity of the to-be-detected battery based on the cell life cycle data comprises:

determining a battery life cycle, battery rated capacity and a battery capacity retention rate from the cell life cycle data; and

calculating a product of the battery life cycle, the battery rated capacity and the battery capacity retention rate as the total discharge capacity of the to-be-detected battery.

3.  The method according to claim 1, further comprising:

acquiring a battery type of the to-be-detected battery; and

searching a battery capacity experimental data table based on the battery type to determine the total discharge capacity corresponding to the to-be-detected battery, and proceeding to the collecting the discharge current of the to-be-detected battery, wherein the battery capacity experimental data table is generated based on the cell life cycle data.

4.  The method according to claim 3, wherein the battery capacity experimental data table is generated based on the cell life cycle data by:

acquiring cell life cycle data of batteries corresponding to a plurality of battery types;

determining, for each of the battery types, total discharge capacity of a battery corresponding to the battery type based on the cell life cycle data of the batteries; and

storing total discharge capacities corresponding to the batteries, and the battery types to the battery capacity experimental data table.

5.  The method according to claim 1, further comprising:

acquiring a cell temperature, a battery SOC, and a voltage of the to-be-detected battery, wherein the cell temperature is N in number, the voltage is M in number, and N and M are both positive integers greater than or equal to 2; and

determining a target discharge current range and a target charge current range based on the cell temperature, the battery SOC and the voltage.

6.  The method according to claim 5, wherein the determining the target discharge current range and the target charge current range based on the cell temperature, the battery SOC and the voltage comprises:

arranging the N cell temperatures in descending order;

arranging the M voltages in descending order; and

determining the target discharge current range and the target charge current range based on the first cell temperature, the Nth cell temperature, the first voltage, the Mth voltage and the battery SOC.

7.  The method according to claim 6, wherein the determining the target discharge current range and the target charge current range based on the first cell temperature, the Nth cell temperature, the first voltage, the Mth voltage and the battery SOC comprises:

querying a current limiting matrix in a data table based on the first cell temperature, the first voltage and the battery SOC, to determine a first discharge current and a first charge current; and

querying the current limiting matrix in the data table based on the Nth cell temperature, the Mth voltage and the battery SOC, to determine a second discharge current and a second charge current.

8.  The method according to claim 5, further comprising:

determining whether the calculated state of health of the to-be-detected battery is lower than previous state of health, wherein the previous state of health is set to an initial value in a case that the state of health of the to-be-detected battery is calculated for the first time; and

correcting the target discharge current range and the target charge current range based on the calculated state of health of the to-be-detected battery, if determined that the calculated state of health is lower than the previous state of health.

9. The method according to claim 1, further comprising:

determining an initial current limiting matrix based on the battery rated capacity in the cell life cycle data; and determining the target discharge current range and the target charge current range based on the initial current limiting matrix.

10. An apparatus for managing a state of health of a battery, comprising:

an acquiring unit configured to acquire cell life cycle data corresponding to a to-be-detected battery; a determining unit configured to determine total discharge capacity of the to-be-detected battery based on the cell life cycle data; a collecting unit configured to collect a discharge current of the to-be-detected battery; and a processing unit configured to calculate first discharge capacity of the to-be-detected battery based on the discharge current, and calculate the state of health of the to-be-detected battery based on the total discharge capacity and the first discharge capacity.

11. An electronic device, configured to execute a program, wherein the program, when executed, performs the method according to any one of claims 1 to 9.

12. A computer storage medium, storing a program, wherein the program, when executed, controls a device where the storage medium is located to perform the method according to any one of claims 1 to 9.

10

20

**Processing module 30**

**Figure 1**

S201 — Acquire cell life cycle data corresponding to a to-be-detected battery

S202 — Determine total discharge capacity of the to-be-detected battery based on the cell life cycle data

S203 — Collect a discharge current of the to-be-detected battery

S204 — Calculate first discharge capacity of the to-be-detected battery based on the discharge current

S205 — Calculate state of health of the to-be-detected battery based on the total discharge capacity and the first discharge capacity

**Figure 2**

S301 — Acquire a battery type and a model of the to-be-detected battery

S302 — Search a battery capacity experimental data table based on the battery type and the model to determine the total discharge capacity corresponding to the to-be-detected battery

S303 — Collect a discharge current of the to-be-detected battery

S304 — Calculate first discharge capacity of the to-be-detected battery based on the discharge current

S305 — Calculate state of health of the to-be-detected battery based on the total discharge capacity and the first discharge capacity

**Figure 3**

S401 — Acquire cell temperature, battery SOC, and voltage of the to-be-detected battery

S402 — Determine a target discharge current range and a target charge current range based on the cell temperature, the battery SOC and the voltage

**Figure 4**

S501

Is
calculated state of health of the to-be-detected battery lower
than previous state of health

Yes

S502

Correct the target discharge current range and the target charge current range
based on the calculated state of health of the to-be-detected battery

**Figure 5**

Acquiring unit 601

Determining unit 602

Processing unit 604

Collecting unit 603

**Figure 6**

# EP 4 481 412 A1

Europäisches Patentamt
European Patent Office
Office européen des brevets

## EUROPEAN SEARCH REPORT

Application Number

EP 23 20 9475

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2016/091573 A1 (SHIRAISHI TAKEYUKI [JP] ET AL) 31 March 2016 (2016-03-31) * abstract * * paragraph [0071] – paragraph [0127]; figures 1-12 * | 1-5,8-12 | INV. G01R31/367 G01R31/374 G01R31/392 |
| X | US 2015/301118 A1 (TAO YOHEI [JP] ET AL) 22 October 2015 (2015-10-22) * abstract * * paragraph [0086] – paragraph [0316]; figures 1-29 * | 1-5,8-12 | |
| X | CN 110 261 790 A (BEIJING HYPERSTRONG TECH CO LTD) 20 September 2019 (2019-09-20) * paragraph [0048] – paragraph [0106]; figures 1-5 * | 1-5,8-12 | |
| X | CN 112 180 277 A (SUNWODA ELECTRIC VEHICLE CELL CO LTD) 5 January 2021 (2021-01-05) * paragraph [0028] – paragraph [0063]; figure 1 * | 1-5,8-12 | |
| X | CN 114 779 094 A (MERCEDES BENZ GROUP AG) 22 July 2022 (2022-07-22) * the whole document * | 1-5,8-12 | TECHNICAL FIELDS SEARCHED (IPC)  G01R |
| X | US 2002/109506 A1 (KAWAKAMI SOICHIRO [JP] ET AL) 15 August 2002 (2002-08-15) * abstract * * paragraph [0090] – paragraph [0568]; figures 1-34 * | 1-5,8-12 | |
| X | US 2021/148988 A1 (GAO KEJIE [CN] ET AL) 20 May 2021 (2021-05-20) * abstract * * paragraph [0063] – paragraph [0160] * | 1-5,8-12 | |
| | -/-- | | |

The present search report has been drawn up for all claims

| Place of search | Date of completion of the search | Examiner |
|---|---|---|
| Munich | 30 April 2024 | Bergado Colina, J |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 1 of 2

Europäisches
Patentamt

European
Patent Office

Office européen
des brevets

# EUROPEAN SEARCH REPORT

Application Number

EP 23 20 9475

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | Gary L Hunt: "FreedomCAR Battery Test Manual For Power-Assist Hybrid Electric Vehicles", <br><br> , <br>1 October 2003 (2003-10-01), XP055316865, Retrieved from the Internet: URL:https://avt.inl.gov/sites/default/files/pdf/battery/freedomcar_manual_04_15_03.pdf <br>[retrieved on 2016-11-07] <br>* the whole document * <br> ----- | 1-5,8-12 | |
| A | US 2013/030739 A1 (TAKAHASHI KENJI [JP] ET AL) 31 January 2013 (2013-01-31) <br>* abstract * <br>* paragraph [0056] - paragraph [0075]; figures 1-4 * <br> ----- | 1-12 | |

TECHNICAL FIELDS
SEARCHED (IPC)

The present search report has been drawn up for all claims

| Place of search | Date of completion of the search | Examiner |
|---|---|---|
| Munich | 30 April 2024 | Bergado Colina, J |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 23 20 9475

This annex lists the patent family members relating to the patent documents cited in the above-mentioned European search report.
The members are as contained in the European Patent Office EDP file on
The European Patent Office is in no way liable for these particulars which are merely given for the purpose of information.

30-04-2024

| Patent document cited in search report | | Publication date | Patent family member(s) | | Publication date |
|---|---|---|---|---|---|
| US 2016091573 | A1 | 31-03-2016 | CN | 105467324 A | 06-04-2016 |
| | | | DE | 102015218674 A1 | 14-04-2016 |
| | | | US | 2016091573 A1 | 31-03-2016 |
| US 2015301118 | A1 | 22-10-2015 | CN | 104813179 A | 29-07-2015 |
| | | | CN | 107102264 A | 29-08-2017 |
| | | | DE | 112013005746 T5 | 10-09-2015 |
| | | | JP | 6237643 B2 | 29-11-2017 |
| | | | JP | 2013253991 A | 19-12-2013 |
| | | | JP | WO2014083853 A1 | 05-01-2017 |
| | | | US | 2015301118 A1 | 22-10-2015 |
| | | | US | 2017123013 A1 | 04-05-2017 |
| | | | WO | 2014083853 A1 | 05-06-2014 |
| CN 110261790 | A | 20-09-2019 | NONE | | |
| CN 112180277 | A | 05-01-2021 | NONE | | |
| CN 114779094 | A | 22-07-2022 | CN | 114779094 A | 22-07-2022 |
| | | | DE | 102023001072 A1 | 05-10-2023 |
| US 2002109506 | A1 | 15-08-2002 | CN | 1340874 A | 20-03-2002 |
| | | | CN | 101034141 A | 12-09-2007 |
| | | | DE | 60132951 T2 | 26-06-2008 |
| | | | EP | 1158306 A2 | 28-11-2001 |
| | | | JP | 5202698 B2 | 05-06-2013 |
| | | | JP | 2011257411 A | 22-12-2011 |
| | | | KR | 20010107687 A | 07-12-2001 |
| | | | KR | 20040014921 A | 18-02-2004 |
| | | | KR | 20040014922 A | 18-02-2004 |
| | | | KR | 20040016807 A | 25-02-2004 |
| | | | KR | 20040016808 A | 25-02-2004 |
| | | | KR | 20040016809 A | 25-02-2004 |
| | | | TW | 535308 B | 01-06-2003 |
| | | | US | 2002109506 A1 | 15-08-2002 |
| US 2021148988 | A1 | 20-05-2021 | BR | 112019021863 A2 | 26-05-2020 |
| | | | CN | 108732500 A | 02-11-2018 |
| | | | CN | 110927605 A | 27-03-2020 |
| | | | EP | 3614157 A1 | 26-02-2020 |
| | | | EP | 3809148 A1 | 21-04-2021 |
| | | | JP | 2020517920 A | 18-06-2020 |
| | | | US | 2020049774 A1 | 13-02-2020 |
| | | | US | 2021148988 A1 | 20-05-2021 |
| | | | WO | 2018192069 A1 | 25-10-2018 |

EPO FORM P0459

For more details about this annex : see Official Journal of the European Patent Office, No. 12/82

page 1 of 2

**ANNEX TO THE EUROPEAN SEARCH REPORT
ON EUROPEAN PATENT APPLICATION NO.**                    EP 23 20 9475

This annex lists the patent family members relating to the patent documents cited in the above-mentioned European search report.
The members are as contained in the European Patent Office EDP file on
The European Patent Office is in no way liable for these particulars which are merely given for the purpose of information.

30-04-2024

| Patent document cited in search report | Publication date | Patent family member(s) | | Publication date |
|---|---|---|---|---|
| US 2013030739 A1 | 31-01-2013 | CN | 102834727 A | 19-12-2012 |
| | | EP | 2557428 A1 | 13-02-2013 |
| | | JP | 5447658 B2 | 19-03-2014 |
| | | JP | WO2011125213 A1 | 08-07-2013 |
| | | US | 2013030739 A1 | 31-01-2013 |
| | | WO | 2011125213 A1 | 13-10-2011 |

EPO FORM P0459

For more details about this annex : see Official Journal of the European Patent Office, No. 12/82

page 2 of 2